Europäisches Patentamt

European Patent Office

Office européen des brevets

(19)

(11) Publication number: **0 181 506 B1**

# EUROPEAN PATENT SPECIFICATION

(45) Date of publication of patent specification: **21.08.91**   (51) Int. Cl.5: **H01L 41/08, G01S 7/52**

(21) Application number: **85112914.8**

(22) Date of filing: **11.10.85**

(54) Flexible piezoelectric transducer assembly.

(30) Priority: **15.10.84 US 661082**

(43) Date of publication of application:
**21.05.86 Bulletin 86/21**

(45) Publication of the grant of the patent:
**21.08.91 Bulletin 91/34**

(84) Designated Contracting States:
**AT BE CH DE FR GB IT LI NL SE**

(56) References cited:
**EP-A- 0 154 706**      **DE-A- 2 926 182**
**FR-A- 1 515 529**      **FR-A- 2 185 800**
**FR-A- 2 254 033**      **GB-A- 749 930**

(73) Proprietor: **Edo Corporation/Western Division
2645 South 300 West
Salt Lake City Utah 84115(US)**

(72) Inventor: **Lapetina, Robert A.
4196 Abinadi Road
Salt Lake City Utah 84117(US)**
Inventor: **Snow, Gordon L.
2748 East 5141 South
Salt Lake City Utah 84117(US)**
Inventor: **Baird, P. David
1376 Lincoln Street
Salt Lake City Utah 84105(US)**

(74) Representative: **Patentanwälte Grünecker,
Kinkeldey, Stockmair & Partner
Maximilianstrasse 58
W-8000 München 22(DE)**

## Description

This invention relates to a piezoelectric transducer assembly having piezoelectric elements embedded or held in a flexible casing.

Piezoelectric elements, primarily crystals and ceramics, are employed in a variety of devices including crystal microphones, ultrasonic devices, accelerometers and oscillators. One of the most common uses of piezoelectric elements is in underwater sonar equipment in which a piezoelectric sonar transducer is stimulated by electrical signals to emit sonar signals which radiate out from the transducer. The sonar signals are reflected from underwater objects and the reflected signals are detected by the transducer which produces electrical signals carrying information about the underwater objects.

Transducers typically used in underwater sonar equipment consist of either a single crystal or ceramic element or a rigid array of elements. It has been recognized that it would be desirable to have a flexible, conformable transducer which could be placed on various shaped surfaces for use. If a rigid transducer were applied to such surfaces and the surfaces were flexed or bent to any extent, the transducer could be damaged. A flexible, conformable transducer, however, would not only allow for ease of attachment to different shaped surfaces, but would also accommodate flexing and bending of the surface on which the transducer was placed.

There have been a number of proposals for providing flexible transducers including grinding up of piezoelectric material, embedding the material in an elastic material, and then attempting to polarize the entire unit so that it will function as a piezoelectric device. This type of unit, however, is typically very difficult to manufacture, sensitive to hydrostatic pressure changes and lacking in uniformity. Also, it is difficult to achieve consistency of characteristics from one unit to the next.

From DE-A-29 26 182 an ultrasonic transducer assembly is known comprising a plurality of transducer elements closely dispose to each other in a common plane and sandwiched between an adaptor body and an attenuator body. The adaptor body and the attenuator body are made from flexible material so that the transducer assembly may be attached to an object having a curved surface. This transducer arrangement is adapted to be used in the nondestructive testing of material, it is not suitable for being used in underwater sonar equipment.

It is the object of the invention to provide a piezoeletric transducer assembly of the afore-mentioned kind which is easy to manufacture, the quality of which can be readily controlled, is fairly immune to high pressures and is susceptible to being used in underwater sonar equipment

This object is attained by the features comprised in claim 1. Preferred embodiments of the invention are the subject matter of the dependent claims.

With the above construction, the encasement holding the piezoelectric elements may be flexed or bent to conform to different mounting surface shapes. Advantageously, each piezoelectric element is polarized prior to installation in the encasement and so manufacture of the transducer assembly is simplified. A variety of materials might be used for the encasement including polyurethane, polyethelene, neoprene rubber, etc.

In the drawings:
The above and other objects, features and advantages of the invention will become apparent from a consideration of the following detailed description presented in connection with the accompanying drawings in which:

FIG. 1 shows a perspective, exploded view of a flexible planar piezoelectric transducer assembly made in accordance with the principles of the present invention;

FIG. 2 is a side, fragmented cross-sectional view of the piezoelectric transducer assembly of FIG. 1;

FIG. 3 is a top, plan, fragmented view of the base portion of a flexible piezoelectric transducer assembly showing triangular-shaped piezoelectric elements; and

FIG. 4 is a side, fragmented cross-sectional view of a flexible piezoelectric transducer assembly which utilizes conductive sheets for carrying electrical signals to and from the piezoelectric elements;

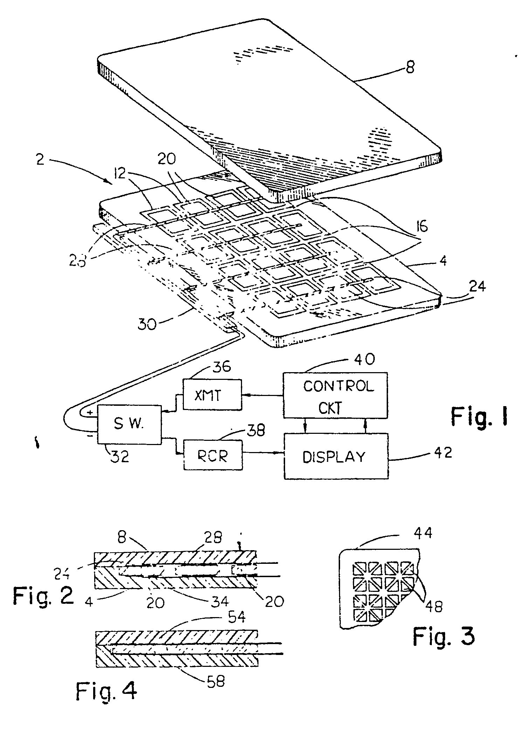

Referring now to the drawings:
Referring to FIG. 1, there is shown an illustrative embodiment of a flexible planar piezoelectric transducer assembly which includes a two-piece housing or casing 2 having a base section 4 and a cover section 8. Both sections are made of a flexible, resilient material such as polyurethane, polyethelene, neoprene rubber, etc. When the cover section 8 is placed over and secured to the base section 4, the casing will present a generally flat profile as best seen in FIG. 2. The cover section 8 may be secured to the base section 4 by a suitable bonding agent such as polyurethane. The casing is formed to be generally square, but could take other shapes such as rectangular, circular, triangular, etc.

Formed in the base section 4 of the casing are a plurality of generally rectangular compartments 12. These compartments are formed to be fairly closely packed and nested in the manner shown in FIG. 1 to provide precise spacing of piezoelectric elements (to be discussed momentarily). Adjacent compartments are separated by walls 16 integrally formed in the base section 4. Alternatively, a single large hollow or compartment may be formed in the base section 4 and then the piezoelectric elements (to be discussed momentarily) positioned in the hollow, separated from one another and held in place by an adhesive.

A plurality of piezoelectric elements 20, either crystal or ceramic, are also provided, with each piezoelectric element being placed in a different one of the compartments and held in place by an adhesive. The piezoelectric elements 20 are formed to fit snugly in each compartment and thus, for the embodiment of FIG. 1, the elements are shown as having a generally rectangular shape to conform to the shape of the compartments. The elements 20 have a thickness which is greater than the depth of the compartments, such thickness being less than the length and width of the elements.

Thin conductive films 24 are placed on the upper and lower surfaces of each of the piezoelectric elements 20 (advantageously during manufacture of the elements) to enable poling of the elements during manufacture and to serve as electrodes for applying electrical signals to the elements. Such films could be any suitable conductive material such as silver, a silver alloy, etc.

The piezoelectric elements 20 are selected to possess low cross-coupling to thereby reduce response in unwanted modes of operation and enable use of the elements over a wide band of frequencies without significant sensitive degradation. Suitable piezoelectric material for achieving this characteristic include lead metaniobate and lead titanate, among others.

Conductive strips of material 28 are placed in contact with each of the conductive films 24 on the upper surfaces of the piezoelectric elements 20, with conductive strips 28 extending through the casing to a bus 30 which is coupled to a transmit/receive switch 32. Conductive strips of material 34 (see FIG. 2) are placed in contact with conductive films positioned on the bottom surfaces of each of the piezoelectric elements 20 to extend through the casing also to the bus 30. The conductive strips 28 and 34 could advantageously be strips of silver, copper, etc., held in contact with the conductive films by spot welding, soldering or conductive adhesive. Alternatively, the conductive strips could be strips of flexible elastomer containing conductive (e.g. silver) particles of flakes. This latter arrangement would provide desired flexibility.

An alternative to the two-piece housing or casing 2 of FIG. 1 would be a one-piece housing made, for example, by first supporting the piezoelectric elements, connecting wires, etc. , in the desired configuration (using suitable tooling fixtures), and then encapsulating the entire array in the encasement material.

The circuitry for producing electrical signals to stress the piezoelectric elements 20, and for detecting the occurrence of stress in the elements includes, in addition to the transmit/receive switch 32, a transmitter 36 and receiver and signal processor 38 both connected to the switch 32, a control circuit 40 connected to the transmitter 36, and a display unit 42 connected to the control circuit 40 and receiver and signal processor 38. The control circuit 40, which might illustratively be a microprocessor, signals the transmitter 36 to apply electrical signals via the transmit/receive switch 32 to the piezoelectric elements 20 to stress the elements. The piezoelectric elements 20 are thus caused to produce, for example, sonar signals for underwater transmission. Reflected sonar signals intercepted by the piezoelectric elements 20 stress the elements and cause them to produce electrical signals which are applied via the switch 32 to the receiver and signal processor 38. The receiver and signal processor 38 processes these signals and then signals the display unit to display information representing the location and shape, for example, of underwater objects from which the sonar signals are reflected. The circuitry described is conventional, shown only for illustrative purposes, and does not form any part of the invention.

The overall size of the transducer assembly could be whatever is desired by the user, but would depend in part on the number of piezoelectric elements to be utilized. Advantageously, the piezoelectric elements 20 would have widths and lengths of between about 3 mm and several cm and would have thicknesses of between about 0,25 mm and 25 mm. These dimensions facilitate ease of manufacture and piezoelectric poling. Of course, the smaller the piezoelectric element, the greater would be the flexibility and conformability of the transducer assembly. Employment of a flexible casing 2 for holding the piezoelectric elements serves not only to accommodate the feature of flexibility and conformability, but also serves to isolate and protect the piezoelectric elements 20 from shock, hydrostatic pressures, water and other fluids in which it would be used, and other external effects. With the generally flat profile of the transducer assembly, the assembly can be readily attached to flat mounting surfaces and to surfaces having shapes which are other than planar and which may change over time.

FIG. 2 shows a side, fragmented cross-sectional view of the transducer assembly of FIG. 1 including the base section 4 and cover section 8 of the casing, the piezoelectric elements 20, and a conductive strip 28 attached to the conductive films or electrodes 24 on the top surface of the piezoelectric elements, and a conductive strip 34 attached to the conductive films or electrodes on the bottom surface of the elements.

FIG. 3 shows a top plan view of a fragmented portion of a base section 44 of a casing, where the compartments 48 are formed in a triangular shape to accommodate triangularly-shaped piezoelectric elements. Of course, a variety of other shapes could also be employed as earlier indicated. It is desirable, however, that the piezoelectric elements be closely packed and nested together and this is accommodated by either the rectangular or triangular shape.

FIG. 4 shows a side, fragmented cross-sectional view of a transducer assembly wherein sheets of conductive material 54 and 58 are respectively placed to contact all of the individual conductive films placed on the upper surfaces of the piezoelectric elements, and to contact all of the films or electrodes on the bottom surfaces of the elements. These conductive sheets would be provided for carrying externally produced signals simultaneously to all of the piezoelectric elements, and for carrying signals produced by all of the elements simultaneously to an external sink. This provision of conductive sheets of material is an alternative to the conductive strips 28 and 34 shown in FIG. 1. Advantageously, the conductive sheets would be made of a composition of conductive particles and an elastomer, to provide flexibility for bending, etc.

## Claims

1. A flexible piezoelectric transducer assembly comprising

    an encasement (2) made of a flexible, resilient material and having a generally flattened side profile, said encasement (2) including a plurality of closely packed compartments (12;48) arranged generally in a plane in the encasement (2), where the compartments (12;48) are polygonal in shape and nested such that adjacent side edges of the compartments (12;48) are generally parallel,

    a plurality of piezoelectric elements (20) being polygonal in shape and dimensioned so that the elements fit snugly in the compartments and selected to have low cross coupling characteristics, each encapsulated in a different compartment (12;48) of the encasement (2), and

    conduction means (24,34;54,58;28) coupled through the encasement (2) to the piezoelectric elements (20) for carrying electrical signals to said elements (20) to stress the elements (20), and for carrying electrical signals produced by said elements (20) when said elements (20) are stressed.

2. A transducer assembly as in Claim 1 wherein said encasement (2) is formed of a generally planar base section (4;44) upper side of which is formed with said compartments (12;48), and a top section (8) for placement on the upper side of the base section (4;44) to enclose the compartments (12).

3. A transducer assembly as in Claim 1 or 2 wherein said encasement (12) is made of polyurethane.

4. A transducer assembly as in Claim 1 or 2 wherein said encasement (2) is made of polyethelene.

5. A transducer assembly as in Claim 1 or 2 wherein said encasement (2) is made of rubber.

6. A transducer assembly as in Claim 1 wherein the compartments (12) and piezoelectric elements (20) are generally rectangular in shape.

7. A transducer assembly as in Claim 1 wherein the compartments (48) and piezoelectric elements are generally triangular in shape.

8. A transducer assembly as in Claim 1 wherein the piezoelectric elements (20) are made of lead titanate.

9. A transducer assembly as in Claim 1 wherein the piezolectric elements (20) are made of lead metaniobate.

10. A transducer assembly as in any one of Claims 1 to 6 wherein the piezoelectric elements (20) are formed generally in squares having a thickness of from about 0,25 mm to 25 mm, and a width of from about 3 mm to about 100 mm.

11. A transducer assembly as in any one of the preceding Claims wherein the piezoelectric elements (20) are held in place in the compartments (12;48) by an adhesive.

12. A transducer assembly as in any one of the preceding Claims wherein the conduction means comprises

    conductive sheets (24,34) disposed on opposing sides of piezoelectric elements (20), and

    conductive strips (28) of material placed in contact with the conductive sheets (24,34) and extending through the encasement (2) to carry electrical signals from an external source (36) to the sheets (24,34), and from the sheets (24,34) to external electronics (38).

13. A transducer assembly as in Claim 12 wherein said conductive strips (28) are composed of a composition of conductive particles and elastomer.

14. A transducer assembly as in any one of Claims 1 to 11 wherein the conduction means comprises

a first sheet (54) of conductive material disposed in contact with one side of each of the piezoelectric elements (20),

a second sheet (58) of conductive material disposed in contact with the other side of each of the piezoelectric elements (20), and

conductors for carrying electrical signals from an external source (36) to the first and second sheets (54,58) of material, and from the first and second sheets (54,58) to external electronics (38).

**Revendications**

1. Dispositif transducteur piézo-électrique flexible comprenant :
   - un boîtier (2) formé d'une matière élastique flexible et présentant un profil latéral généralement aplati, ce boîtier (2) comportant une multiplicité de compartiments (12;48) étroitement tassés, disposés généralement dans un plan dans le boîtier (2), ces compartiments (12;48) ayant une forme polygonale et étant serrés de telle sorte que des bords latéraux adjacents des compartiments (12;48) soient généralement parallèles;
   - une multiplicité d'éléments piézo-électriques (20), de forme polygonale , dimensionnés de telle sorte que ces éléments se logent étroitement dans les compartiments et étant choisis pour avoir de faibles caractéristiques de couplage transversal, chacun étant encapsulé dans un compartiment différent (12;48) du boîtier (2); et
   - des moyens de conduction (24,34;54,58;28) couplés à travers le boîtier (2) aux éléments piézo-électriques (20) pour transmettre des signaux électriques à ces éléments (20) pour contraindre les éléments (20), et pour transmettre les signaux électriques produits par les éléments (20) lorsque ceux-ci sont contraints.

2. Dispositif transducteur selon la revendication 1, dans lequel le boîtier (2) est formé d'une section de base généralement plane (4;44), dont une face supérieure est formée avec les compartiments (12;48), et d'une section supérieure (8) propre à être placée sur la face supérieure de la section de base (4;44) pour fermer les compartiments (12).

3. Dispositif transducteur selon la revendication 1 ou la revendication 2, dans lequel le boîtier (2) est formé de polyuréthane.

4. Dispositif transducteur selon la revendication 1 ou la revendication 2, dans lequel le boîtier (2) est formé de polyéthylène.

5. Dispositif transducteur selon la revendication 1 ou la revendication 2, dans lequel le boîtier (2) est formé de caoutchouc.

6. Dispositif transducteur selon la revendication 1, dans lequel les compartiments (12) et les éléments piézo-électriques (20) ont une forme générale rectangulaire.

7. Dispositif transducteur selon la revendication 1, dans lequel les compartiments (48) et les éléments piézo-électriques ont une forme généralement triangulaire.

8. Dispositif transducteur selon la revendication 1, dans lequel les éléments piézo-électriques (20) sont en titanate de plomb.

9. Dispositif transducteur selon la revendication 1, dans lequel les éléments piézo-électriques (20) sont en métaniobate de plomb.

10. Dispositif transducteur selon l'une des revendications 1 à 6, dans lequel les éléments piézo-électriques (20) sont formés généralement en carrés ayant une épaisseur comprise entre environ 0,25 mm et 25 mm, et une largeur comprise entre environ 3 mm et environ 100 mm.

11. Dispositif transducteur selon l'une quelconque des revendications précédentes, dans lequel les éléments piézoélectriques (20)sont maintenus en place dans les compartiments (12;48) par un adhésif.

12. Dispositif transducteur selon l'une quelconque des revendications précédentes, dans lequel les moyens de conduction comprennent :
   - des feuilles conductrices (24,34) disposées sur des faces opposées des éléments piézo-électriques (20), et
   - des bandes d'une matière conductrice (28) placées au contact des feuilles conductrices (24,34) et s'étendant à travers le boîtier (2) pour transmettre des signaux électriques d'une source extérieure (36) aux feuilles (24,34), et des feuilles (24,34) à une électronique extérieure (38).

13. Dispositif transducteur selon la revendication 12, dans lequel les bandes conductrices (28) sont constituées d'une composition de particules conductrices et d'élastomère.

14. Dispositif transducteur selon l'une quelconque des revendications 1 à 11, dans lequel les moyens de conduction comprennent :
 - une première feuille (54) de matière conductrice disposée en contact avec une face de chacun des éléments piézo-électriques (20),
 - une deuxième feuille (58) de matière conductrice disposée en contact avec l'autre face de chacun des éléments piézo-électriques (20), et
 - des conducteurs pour transmettre des signaux électriques en provenance d'une source extérieure (36) aux première et deuxième feuilles (54,58) de matière, et des première et deuxième feuilles (54,58)à une électronique extérieure (38).

**Patentansprüche**

1. Flexible piezoelektrische Wandleranordnung, enthaltend

ein Gehäuse (2) aus einem flexiblen, nachgiebigen Material und im wesentlichen flachen Seitenprofil, welches Gehäuse (2) mehrere eng benachbarte Abteile (12;48) enthält, die im wesentlichen in einer Ebene in dem Gehäuse (2) angeordnet sind, wobei die Abteile (12;48) eine polygonale Gestalt aufweisen und derart angeordnet sind, daß benachbarte Seitenränder der Abteile (12;48) im wesentlichen parallel sind,

mehrere piezoelektrische Elemente (20), die eine polygonale Gestalt aufweisen und derat bemessen sind, daß die Elemente eng in die Abteile passen, und die derart ausgewählt sind, daß sie niedrige Übersprechkopplungseigenschaften aufweisen, jedes in einem anderen Abteil (12;48) des Gehäuses (2) angeordnet, und

Leitereinrichtungen (24,34;54,58;28), die durch das Gehäuse (2) mit den piezoelektrischen Elementen (20) verbunden sind, um elektrische Signale den genannten Elementen (20) zuzuführen, um die Elemente (20) zu belasten, und zum Fortführen elektrischer Signale, die von den Elementen (20) erzeugt werden, wenn die Elemente (20) belastet werden.

2. Wandleranordnung nach Anspruch 1, bei der das Gehäuse (2) aus einem im wesentlichen ebenen Basisteil (4;44), dessen Oberseite mit den Abteilen (12;48) versehen ist und einem Deckteil (8) zum Aufsetzen auf die Oberseite des Basisteils (4;44) zum Verschließen der Abteile (12) besteht.

3. Wandleranordnung nach Anspruch 1 oder 2, bei der das Gehäuse (2) aus Polyurethan besteht.

4. Wandleranordnung nach Anspruch 1 oder 2, bei der das Gehäuse (2) aus Polyethylen besteht.

5. Wandleranordnung nach Anspruch 1 oder 2, bei der das Gehäuse (2) aus Gummi besteht.

6. Wandleranordnung nach Anspruch 1, bei der die Anteile (12) und die piezoelektrischen Elemente (20) im wesentlichen rechteckige Gestalt haben.

7. Wandleranordnung nach Anspruch 1, bei der die Anteile (48) und die piezoelektrischen Elemente im wesentlichen dreieckige Gestalt haben.

8. Wandleranordnung nach Anspruch 1, bei der die piezoelektrischen Elemente (20) aus Bleititanat bestehen.

9. Wandleranordnung nach Anspruch 1, bei der die piezoelektrischen Elemente (20) aus Bleimetaniobat bestehen.

10. Wandleranordnung nach einem der Ansprüche 1 bis 6, bei der die piezoelektrischen Elemente (20) im wesentlichen quadratisch sind und eine Dicke von etwa 0,25 mm bis etwa 25 mm aufweisen und eine Breite von etwa 3 mm bis etwa 100 mm haben.

11. Wandleranordnung nach einem der vorhergehenden Ansprüche, bei der die piezoelektrischen Elemente (20) in den Anteilen (12;48) durch einen Klebstoff festgehalten werden.

12. Wandleranordnung nach einem der vorhergehenden Ansprüche, bei der die Leitereinrichtung enthält:

leitfähige Folien (24,34), die auf gegenüberliegende Seiten der piezoelektrischen Elemente (20) angeordnet sind, und

leitfähige Materialstreifen (28), die mit den leitfähigen Folien (24,34) in Berührung sind und sich durch das Gehäuse (2) erstrecken, um elektrische Signale von einer äußeren Quelle (36) zu den Folien (24,34) zu führen und von den Folien (24,34) zu äußeren elektronischen Einrichtungen (38) zu führen.

13. Wandleranordnung nach Anspruch 12, bei der die leitfähigen Streifen (28) aus einer Zusammensetzung aus leitfähigen Partikeln und einem Elastomer bestehen.

14. Wandleranordnung nach einem der Ansprüche 1 bis 11, bei der die Leitereinrichtung enthält:

eine erste Folie (54) aus einem leitfähigen Material, die mit einer Seite eines jeden der piezoelektrischen Elemente (20) in Berührung ist,

eine zweite Folie (58) aus leitfähigem Material, die mit der anderen Seite eines jeden der piezoelektrischen Elemente (20) in Berührung ist, und

Leiter zum Zuführen elektrischer Signale von einer äußeren Quelle (36) zu den ersten und zweiten Materialfolien (54,58) und von den ersten und zweiten Folien (54,58) zu äußeren elektronischen Einrichtungen (38).

Fig. 1

Fig. 2

Fig. 3

Fig. 4